# EUROPÄISCHE PATENTSCHRIFT

(11) **EP 3 009 220 B1**
(45) Veröffentlichungstag und Bekanntmachung des Hinweises auf die Patenterteilung: **19.12.2018**
(21) Anmeldenummer: 14189335.4
(22) Anmeldetag: 17.10.2014
(51) Int. Cl.: B23K 1/00, B23K 1/008, H05K 3/34

(54) **Rolle-zu-Rolle-Fertigungsanlage und -verfahren für verkettete kontinuierliche und diskontinuierliche Verarbeitungsprozesse**
Roller to roller production assembly for and method of concatenated continuous and discontinuous processing processes
Installation et procédé de fabrication bobine à bobine pour processus de traitement régulés, continus et discontinus

(43) Veröffentlichungstag der Anmeldung: 20.04.2016
(73) Patentinhaber: Rehm Thermal Systems GmbH, 89143 Blaubeuren-Seissen (DE)
(72) Erfinder: Kuhn, Jochen, 89143 Blaubeuren-Seißen (DE); Oettl, Helmut, 89143 Blaubeuren-Seißen (DE)
(74) Vertreter: Grünecker Patent- und Rechtsanwälte PartG mbB

(56) Entgegenhaltungen:
- EP-A1- 2 160 263
- US-A1- 2004 245 316
- US-B2- 7 288 742

## Beschreibung

### Gebiet der Erfindung

Die vorliegende Erfindung betrifft eine Endlosfertigungsanlage, insbesondere eine Rolle-zu-Rolle-Endlosfertigungsanlage, zum Verarbeiten eines bandförmigen Substrats gemäß dem Oberbegriff des Anspruchs 1 (siehe, z.B., US2004/245316 A1). Die vorliegende Erfindung betrifft auch ein Verfahren zur Endlosfertigung eines Produkts auf einem bandförmigen Substrat gemäß dem Oberbegriff des Anspruchs 8.

### Stand der Technik

Eine solche Vorrichtung ist beispielsweise aus der zur Erteilung eines Patents vorgesehenen Patentanmeldung mit der Veröffentlichungs-Nr. EP 21 60 263 mit dem Titel " REFLOW-LÖTANLAGE MIT AN EXTERNE TRANSPORTGESCHWINDIGKEITEN ANPASSBAREM TEMPERATURPROFIL" bekannt.

Anlagen für die Rolle-zu-Rolle-Endlosfertigung (Reel-2-Reel) werden beim Reflow-Löten von elektronischen Baugruppen auf flexiblen Folien eher selten eingesetzt. Das hauptsächliche Hindernis besteht in der Verkettung des Reflow-Prozesses mit den anderen vorgelagerten Prozessschritten, beispielsweise dem Aufdruck einer Paste für die Leiterbahnen und das Bestücken mit elektrischen und elektronischen Bauelementen. Während z.B. der Druckvorgang zum Auftragen der Paste und das Bestücken sequentiell (diskontinuierlich) erfolgen, d.h., das Band steht während der Durchführung dieser Prozesse, muss der Reflow-Prozess aufgrund der thermischen Anforderungen kontinuierlich ablaufen.

Zur Herstellung der elektrischen Verbindungen zwischen den Bauelementen wird das bandförmige Substrat zunächst mit Lotpaste bedruckt und anschließend mit den Bauelementen bestückt. Nach dem Bestücken setzt sich das Band in Bewegung und der bestückte Teil des bandförmigen Endlossubstrats läuft in die Anlage zum Umschmelzen der Lotpaste. Der Aufschmelzvorgang ist dabei in einer gesteuerten Weise durchzuführen, der u.a. von den Eigenschaften der Lotpaste, der Bauelemente, der Bestückungsdichte usw. abhängt. Beispielsweise sind bei Bauelementen mit sehr unterschiedlicher Baugröße die unterschiedlich langen Aufheizzeiten zu berücksichtigen, um die Lotpaste aufzuschmelzen und damit die gewünschte Qualität der Verbindung im Hinblick auf die elektrischen, thermischen und mechanischen Eigenschaften zu gewährleisten. Daher verläuft in der Regel der Lötvorgang in der Anlage gemäß einem spezifizierten Ablauf, um damit ein gewünschtes Temperaturprofil auf dem Substrat zu erzeugen, so dass einerseits eine zuverlässige Verflüssigung der Lotpaste innerhalb eines gewünschten Zeitraums stattfindet, aber andererseits eine Überhitzung empfindlicher Bauelemente nicht stattfindet. Eine Unterbrechung des Transportvorganges stört deshalb empfindlich den Aufheizungsprozess und führt zu nicht reproduzierbaren Produktergebnissen .

In der Veröffentlichung "Rolle-zu-Rolle-Fertigung von MID-basierten Mikrosystemen" von Dr. Hans Bell, Michael Gempp und Stefan Schulz, veröffentlicht in PLUS 7/2014, Seiten 1544 ff. wird das Problem der verketteten kontinuierlichen und diskontinuierlichen Prozessschritte durch ein Trägerband mit eingeknüpften Warenträgern gelöst. Einzelne Warenträger können aus dem Trägerband ausgeknüpft werden, um ihn beispielsweise einem kontinuierlichen Temperierungsprozess zuzuführen. Nach der Durchführung des kontinuierlichen Prozesses wird der Warenträger wieder in das Endlosband eingeknüpft. Der apparative Aufwand für diese Lösung ist hoch, da getrennte Transporteinrichtungen für die diskontinuierlichen und kontinuierlichen Prozesse bereitgestellt werden müssen und verzahnte Transportbänder aufwändig hergestellt werden müssen, beispielsweise in einem Endlosspritzgießverfahren. Weiterhin müssen Vorrichtungen bereitgestellt werden zum Aus- und Einknüpfen der verzahnten Warenträger in dem verzahnten Transportband.

Das Problem, dass Schwierigkeiten auftreten, wenn ein Substrat von einer Bearbeitungsstation zur nächsten geführt wird, wie dies beispielsweise beim Verarbeiten von endlosen flexiblen Substraten der Fall ist, da dann der bestimmende Linientakt mit den thermodynamischen Erfordernissen des Aufschmelzlötvorgangs in Einklang zu bringen ist, wird auch in der EP 21 60 263 aufgegriffen. Dort wird beschrieben, dass ein "endloses" Substrat in Reihe angeordnete gleiche Abschnitte, beispielsweise Schaltungen oder Leiterplatten aufweist, die auch als "Images" bezeichnet werden, wobei zwischen den einzelnen Schaltungen meist nur einige Millimeter Substrat vorhanden sind, um beispielsweise den späteren Trennvorgang zu ermöglichen. Um einen kontinuierlichen Transportvorgang in der Reflow-Lötanlage zu ermöglichen, wird ein "Puffer" in Form einer losen Schleife vor der Anlage vorgesehen, um damit den unterschiedlichen Transportgeschwindigkeiten und -verfahren der einzelnen Bearbeitungsanlagen, d.h. der Bestückungseinrichtung, der Aufdruckeinrichtung und der Reflow-Prozessanlage, Rechnung zu tragen. Um flexibel Heizprofile einstellen zu können, wird in der EP 21 60 263 eine Wärmequelle in Form einer segmentierten Wärmeleitoberfläche bereitgestellt. Einzelne Segmente können ausgetauscht werden, um flexibel ein Temperaturprofil einzustellen. Dazu sind die einzelnen Segmente mit Antriebseinheiten versehen, mit denen die Heizplattensegmente senkrecht zur Transportrichtung oder parallel zur Transportrichtung verschoben werden können. Wird beispielsweise ein Heizsegment durch ein Kühlsegment ersetzt, wird das Heizsegment senkrecht zur Transportrichtung des Substratbands aus dem Heizbereich herausgeschoben und ein Kühlsegment eingeschoben. Sollen im Vergleich zum auszutauschenden Segment kleinere oder größere Segmente in den Heizbereich eingefügt werden, müssen die angrenzenden Segmente entlang der Transportrichtung verschoben werden, um einen möglichst lückenlosen Heiz-/Kühlbereich bereitzustellen. Obwohl in der EP 21 60 263 einzelne Heizelemente relativ zu dem bandförmigen Substrat beweglich sind, ist ein kontinuierlicher Lötvorgang nur möglich, wenn sich das bandförmige Substrat in Abstimmung mit dem Temperaturprofil des Heizbereichs bewegt. Die Angleichung der Bandbewegung zwischen dem vorgelagerten diskontinuierlichen Bedruckungs- und Bestückungsprozess und dem nachfolgenden kontinuierlichen Lötprozess erfolgt ausschließlich über den Bandpuffer in Form einer Bandschleife. Dies ist jedoch technisch schwer zu realisieren, da durch die starken Krümmungen des bandförmigen Substrats Probleme bei der Haftung des Lots und der elektrischen Bauteile bestehen.

Es ist deshalb eine Aufgabe der vorliegenden Erfindung, eine Endlosfertigungsanalage bereitzustellen, die kontinuierliche thermische Verarbeitungsprozesse und diskontinuierliche Verarbeitungsprozesse wie beispielsweise Bestückungsprozesse auf kostengünstige Weise miteinander verkettet. Es ist weiterhin eine Aufgabe der vorliegenden Erfindung, ein Verfahren für eine Endlosfertigung von elektrischen bzw. elektronischen Produkten bereitzustellen, mit dem diskontinuierliche Arbeitsschritte und kontinuierliche Arbeitsschritte kostengünstig miteinander verketten werden können.

US-A1-2004/0245316 und US-A1-2007/0075068 betreffen Endlosfertigungsanlagen mit einer Reflow Heizvorrichtung gemäß dem Stand der Technik.

### Zusammenfassung der Erfindung

Die Aufgabe wird durch eine Endlosfertigungsanlage gemäß Anspruch 1 gelöst.

Insbesondere wird die Aufgabe gelöst durch eine Endlosfertigungsanlage der Eingangs genannten Art, die gekennzeichnet ist durch eine zweite Antriebseinrichtung zum Bewegen der Wärmequelle relativ zu der ersten Prozesszone entlang des bandförmigen Substrats, die dafür ausgelegt ist, die Wärmequelle relativ zu der ersten Prozesszone entlang des bandförmigen Substrats entgegen der Transportrichtung des bandförmigen Substrats zu bewegen, selbst wenn die erste Antriebseinrichtung stillsteht.

Die erfindungsgemäße Endlosfertigungsanlage bewirkt, dass das für einen Lötprozess erforderliche Temperaturprofil durch die Bewegung der Wärmequelle entgegen der Bandlaufrichtung erzeugt wird. Dies beinhaltet, dass der Mechanismus zum Bewegen der Wärmequelle so ausgelegt ist, dass die Wegstrecke groß genug ist, um entsprechende Temperaturprofile zu erzeugen.

Gemäß der Erfindung umfasst die Endlosfertigungsanlage weiterhin eine Steuerungseinrichtung, die ausgelegt ist, die zweite Antriebseinrichtung so zu steuern, dass die Wärmequelle so bewegt wird, dass ein für den Lötprozess erforderliches vorbestimmtes Temperaturprofil T(t) über einem vorbestimmten Bereich des bandförmigen Substrats erreicht wird.

Die Temperaturprofile werden dadurch erzeugt, dass entgegen der Transportrichtung des Bandes die Wärmequelle bewegt wird. Dadurch kann ein Durchlaufprinzip simuliert werden, so dass ein kontinuierlicher Temperierungsprozess für ein Produkt auf dem bandförmigen Substrat durchgeführt werden kann, selbst wenn das bandförmige Substrat steht, um an einer anderen Stelle des bandförmigen Substrats Lot aufzutragen und die Leiterbahnen mit elektrischen Bauelementen zu bestücken. Das heißt, der kontinuierliche thermische Prozess kann durchgeführt werden unabhängig von anders getakteten vor- bzw. nachgelagerten Verarbeitungsschritten.

Durch die Wärmebehandlung während der zur Transportrichtung des Bandes gegenläufigen Bewegung der Wärmequelle ist es weiterhin möglich, eine bessere thermische Trennung zu nachfolgenden Images, die in die Reflow-Lötanlage eintreten, zu erreichen. Wird nämlich die Wärmequelle beim Zurückführen in die Ausgangsposition abgeschaltet, kann der temperaturbehandelte Bereich kontrolliert abkühlen, und ein Wärmeübertrag auf die nachfolgenden Produkte wird geringer. Dies ist dann von besonderem Vorteil, wenn nachfolgende Images ein anderes Temperaturprofil benötigen und Temperatureinflüsse vorausgehender Produkte das Temperaturprofil stören würden.

Weiterhin ist es durch die Wärmebehandlung während der zur Transportrichtung des Bandes gegenläufigen Bewegung der Wärmequelle möglich, beliebige Produktlängen, die auch als Imagelängen bezeichnet werden, auf dem Band zu verarbeiten. Die maximale Imagelänge wird nur durch den Fahrweg des Wärmefeldes bestimmt. Die Bandgeschwindigkeit muss dabei auf die Imagelänge eingestellt werden. Die Bandgeschwindigkeit kann aber auch das Temperaturprofil beeinflussen. Um die Fertigungsanlage möglichst flexibel und präzise nutzen zu können, ist in einer Ausführungsform die Steuerungseinrichtung ausgelegt, die Transportgeschwindigkeit des bandförmigen Substrats abhängig von der Produktlänge und/oder dem vorbestimmten Temperaturprofil zu steuern.

Das Temperaturprofil wird bei Stillstehen des Bandes durch die Temperaturverteilung des Wärmefelds und durch die Geschwindigkeit, mit der die Wärmequelle bewegt wird, bestimmt. Im einfachsten Fall kann ein gewünschtes Temperaturprofil beispielsweise mit einer punktförmigen Wärmequelle, deren Wärmeenergie auf einen Punkt oder eine Linie auf dem Substrat fokussiert, erreicht werden. Dies entspräche einem eng begrenzten linienförmigen Wärmefeld. In diesem Fall wird das Temperaturprofil durch die Geschwindigkeit und die Strahlungsintensität der Wärmequelle bestimmt. Die Gestalt des Wärmefelds spielt eine untergeordnete Rolle.

In einer Ausführungsform kann die Wärmequelle aber auch segmentiert sein, so dass Wärmefelder mit beliebiger Gestalt oder auch mehrere räumlich getrennte Wärmefelder mit vorgegebenen Temperaturverteilungen erzeugt werden können. Durch ausgedehntere Wärmefelder können unter Umständen die Durchlaufzeiten verkürzt werden und auch gleichmäßigere Temperaturverteilungen erreicht werden.

Gemäß der Erfindung ist die Steuerungseinrichtung ausgelegt, die Intensität der mindestens einen Wärmequelle bzw. die einzelnen Segmente der Wärmequelle abhängig von dem vorbestimmten Temperaturprofil individuell so zu steuern, dass ein Wärmefeld mit einer vorgegebenen Temperaturverteilung entsteht. Je nach Produktgrößen und Bauteilehöhen sind unterschiedliche Temperaturprofile nötig, um einen optimalen Lötprozess durchzuführen. Um die Flexibilität des Reflow-Lötprozesses zu erhöhen, ermöglicht diese Ausführungsform eine individuelle Gestaltung der Wärmefelder beispielsweise durch Ansteuerung von einzelnen Segmenten der Wärmequelle.

In einer weiteren Ausführungsform sind am Einlauf und/oder Auslauf der Reflow-Lötprozessanordnung zusätzliche Wärmequellen stationär oder mit dem bandförmigen Substrat bewegbar angeordnet. Dies hat den Vorteil, dass ein undefinierter Wärmeentzug durch das Bandmaterial verringert wird, da das Bandmaterial auf einer definierten Temperatur gehalten wird.

In einer weiteren Ausführungsform umfasst die Endlosfertigungsanlage weiterhin mindestens eine Temperaturmesseinrichtung, über die die Steuerungseinrichtung die Bewegung des bandförmigen Substrats und/oder die Bewegung der mindestens einen Wärmequelle und/oder die Form des Wärmefeldes der Wärmequelle beispielsweise durch Steuern der Intensität der Segmente der Wärmequelle steuern kann, um ein gewünschtes Wärmeprofil zu erreichen. Dabei kann die Temperaturmesseinrichtung ein Pyrometer, einen Thermofühler, eine Thermokamera, ein Thermoelement oder Kombinationen daraus umfassen, die an einem ausgewählten Punkt oder an mehreren ausgewählten Punkten im Prozessbereich angeordnet sein können.

Dadurch lassen sich die Temperaturprofile in einem Regelkreis besser einstellen und man erhält reproduzierbare Lötergebnisse.

Als Wärmequellen können Infrarotstrahler beispielsweise als Flächenstrahler oder fokussierte Strahler, beheizte Wärmeleiter wie beispielsweise Heizplatten oder Kühlplatten, Konvektionswärmequellen wie beispielsweise Heißluftgebläse, Kondensationswärmequellen oder Laserwärmequellen oder eine Kombination daraus umfassen. Bei der Rolle-zu-Rolle-Fertigung haben sich Konvektionswärmequellen bewährt, so dass bekannte Anlagentechnik günstig verwendet werden kann. Im beanspruchten System mit gegenläufig bewegter Wärmequelle stellt ein Infrarotstrahler insbesondere ein fokussierter Infrarotstrahl eine einfache und günstige Möglichkeit dar, ein gewünschtes Wärmeprofil zu erzeugen. Die Infrarotstrahler lassen sich auch als Array leicht realisieren, so dass auch kompliziertere Wärmefelder erzeugt werden können. Mit fortschreitender Technik von Halbleiterlasern und lichtemittierenden Dioden (LED) finden auch Leuchtdioden (LED) und Halbleiterlaser, insbesondere vertikal emittierende Halbleiterlaser (VCSEL) Verwendung als Infrarotstrahlungsquelle. Zum gezielten Kühlen können auch gekühlte bzw. beheizte Wärmeleiter wie beispielsweise Wärmeplatten/Kälteplatten verwendet werden.

Das obengenannte Problem wird auch durch ein Verfahren zur Endlosfertigung eines Produkts auf einem bandförmigen Substrat gemäß Anspruch 8 gelöst.

Wie oben bereits erwähnt, weist dieses Verfahren den Vorteil auf, dass der diskontinuierliche Prozess des Bedruckens und des Bestückens des bandförmigen Substrats, d.h. den Arbeitsprozessen bei stillstehendem Band, mit dem kontinuierlichen thermischen Prozess (d.h. dem Prozess, der eine Bewegung des Bands relativ zur Prozesszone erfordert, verkettet werden kann). Das heißt, der kontinuierliche Prozess kann durchgeführt werden unabhängig von den Takten der diskontinuierlichen Prozesse.

Gemäß der Erfindung für das Verfahren umfasst der zweite Verfahrensschritt weiterhin das Einschalten und Steuern der Wärmequelle, um ein vorgegebenes Temperaturprofil zu erzeugen. Das Steuern der Wärmequelle umfasst mindestens eins der folgenden: Steuern der Intensität der Wärmequelle oder von Segmenten einer segmentierten Wärmequelle, um ein Wärmefeld mit vorgegebener Temperaturverteilung zu erzeugen; und Steuern der Bewegung der Wärmequelle. Dadurch lassen sich beliebige Temperaturprofile erzeugen und die Anlage kann flexibel für unterschiedliche Images und Imagegrößen genutzt werden.

In einer weiteren Ausführungsform umfasst der zweite Verfahrensschritt weiterhin: Erfassen der Temperatur an mindestens einer Stelle des bandförmigen Substrats in der zweiten Prozesszone; Messen eines Temperaturprofils des bandförmigen Substrats in der zweiten Prozesszone; Vergleichen des gemessenen Temperaturprofils mit dem vorgegebenen Temperaturprofil; und Steuern der Wärmequelle, um eine Differenz zwischen dem vorgegebenen und dem gemessenen Temperaturprofil zu minimieren. Dadurch erhält man reproduzierbarere Ergebnisse für den Lötprozess.

In einer anderen Ausführungsform umfasst das Verfahren weiterhin einen dritten Verfahrensschritt des Startens der Transportbewegung des bandförmigen Substrats; und einen vierten Verfahrensschritt des Umkehrens der Bewegungsrichtung der Wärmequelle. Der dritte und vierte Verfahrensschritt erfolgt, wenn die diskontinuierlichen Prozesse wie Pastenauftrag des Lots und Bestücken beendet werden und der nächste Abschnitt des bandförmigen Substrats zu den Prozesszonen transportiert wird. Der dritte und vierte Verfahrensschritt kann so ausgeführt werden, dass der thermische Prozess kontinuierlich weiterläuft. Es ist jedoch auch vorteilhaft, die Wärmequelle abzuschalten, solange sie sich in der gleichen Richtung wie die Transportrichtung des bandförmigen Substrats bewegt, um ein kontrolliertes Abkühlen des temperierten Substratabschnitts zu ermöglichen, und um die Wärmeausbreitung entlang des Substratbandes zu verringern.

Wird die Wärmequelle nicht abgeschaltet, kann die Bewegung der Wärmequelle so gesteuert werden, dass immer eine Relativbewegung mit konstanter Geschwindigkeit zwischen Heizquellen und Substrat vorliegt, selbst wenn das bandförmige Substrat relativ zu der zweiten Prozesszone ruht. In diesem Fall erfolgt eine kontinuierliche, d.h. unterbrechungslose Wärmebehandlung des Substratmaterials, egal ob das bandförmige Substrat sich bewegt oder steht.

Anzumerken wäre, dass die beschriebenen Verfahrensschritte (erster Verfahrensschritt, zweiter Verfahrensschritt, dritter Verfahrensschritt, vierter Verfahrensschritt) hintereinander ausgeführt werden, während die Abläufe innerhalb eines Verfahrensschritts gleichzeitig stattfinden können.

### Kurze Beschreibung der Figuren

Im Folgenden werden Ausführungsbeispiele, Weiterbildungen, Vorteile und Anwendungsmöglichkeiten der Erfindung anhand der beigefügten Figuren näher erläutert. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen, oder deren Rückbeziehung. Auch wird der Inhalt der Ansprüche zu einem Bestandteil der Beschreibung gemacht. In den Figuren zeigt:
- Fig. 1: eine Ausführungsform der Endlosfertigungsanlage gemäß der vorliegenden Erfindung;
- Fig. 2: eine Temperaturverteilung einer fokussierten Infrarotwärmequelle;
- Fig. 3: ein Temperaturprofil in einem Reflow-Lötprozess;
- Fig. 4: ein Beispiel für ein Wärmefeld in einer segmentierten Wärmequelle; und
- Fig. 5: ein Beispiel für räumlich getrennte Wärmefelder, die durch eine Aneinanderreihung von mehreren segmentierten Wärmequellen erzeugt werden können.

### Ausführliche Beschreibung von Ausführungsformen

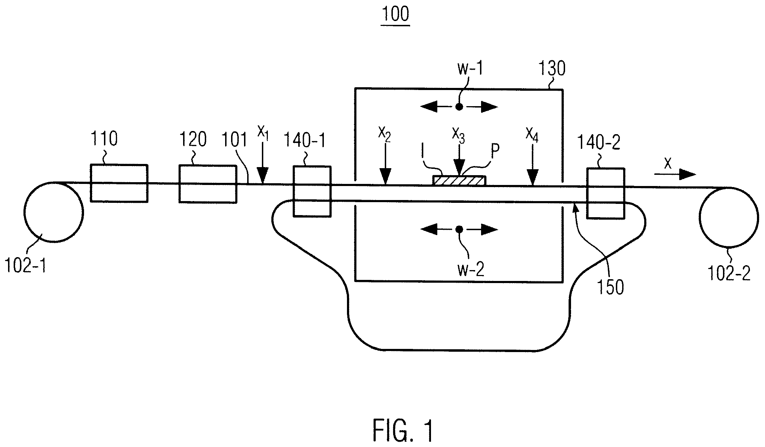

Fig. 1 zeigt eine Endlosfertigungsanlage für Rolle-zu-Roll-Fertigung von elektronischen Produkten, indem ein bandförmiges Substrat 101 verarbeitet wird. Das bandförmige Substrat 101 besteht aus einem flexiblen Material, beispielsweise aus Kunststoff, einem Textilgewebe, oder Metall wie beispielsweise Kupfer, das von einer Rolle 102-1 an der Eingangsseite der Anlage 100 abgerollt wird, in der Anlage 100 bearbeitet wird und auf der Ausgangsseite der Anlage 100 auf einer Rolle 102-2 wieder aufgewickelt wird. Das bandförmige Substrat 101 läuft durch die Anlage 100 und wird in den Prozesszonen 110, 120 und 130 bearbeitet. Die Prozesszone 110 kann beispielsweise eine Druckstation zum Aufdrucken der Lotpaste auf das Band 101 sein, die Station 120 kann eine Bestückungsstation sein, in der entsprechende Bauelemente automatisch aufgebracht werden, und die Station 130 repräsentiert eine Reflow-Lötanlage. Die Transportrichtung des bandförmigen Substrats 101 wird mit X bezeichnet (siehe Pfeil auf der rechten Seite der Fig. 1). Die Reflow-Lötanlage 130 ist in der in Fig. 1 dargestellten Anordnung in einer Kammer untergebracht mit einer Einlass- und einer Auslassöffnung, durch die das bandförmige Substrat 101 durchgeht. In der Kammer der Reflow-Lötanlage wird eine Wärmequelle gezeigt, die symmetrisch oberhalb und unterhalb des bandförmigen Substrats 101 angeordnet ist (Bezugszeichen W-1 und W-2). Zur präziseren Einstellung des Temperaturprofils ist die Wärmequelle W oberhalb und unterhalb des bandförmigen Substrats 101 angeordnet. Die Pfeile in Fig. 1 rechts und links der Wärmequellen W-1 und W-2 zeigen an, dass die Wärmequellen W-1 und W-2 synchron zueinander entlang des bandförmigen Substrats 101 bewegt werden können. Die zweiteilige Form der Wärmequelle W-1 und W-2 ist jedoch nicht zwingend notwendig, da auch mit nur einer Wärmequelle W-1 über dem bandförmigen Substrat Temperaturprofile realisiert werden können. Eine Auflage 150 für das bandförmige Substrat 101, das aus einem hitzebeständigen Material mit geringen Gleitreibungswerten wie beispielsweise Teflon besteht, dient als Unterstützung des bandförmigen Substrats, so dass Verformungen des bandförmigen Substrats 101 wie beispielsweise Wellen oder seitliche Krümmung des Bands aufgrund der Wärmeeinwirkung in der Reflow-Prozessanordnung 130 geglättet werden. Zur Absicherung des undefinierten Wärmeentzugs durch das Bandmaterial werden zusätzlich eine Wärmequelle 140-1 am Eingang und eine Wärmequelle 140-2 am Ausgang der Anlage angeordnet, die das Bandmaterial auf einer definierten Temperatur halten. Die Wärmequellen 140-1 und 140-2 können stationär sein oder auch mitbewegt werden. Fig. 1 zeigt auch ein Produkt I (Image) unterhalb der Wärmequelle W-1.

Im Folgenden wird das Verfahren beschrieben, mit dem ein Produkt I (Image) auf dem Weg von der Spenderrolle 102-1 durch die Prozesszonen 110, 120 und 130 zur Aufnahmerolle 102-2 bearbeitet wird. Zunächst ist das Produkt ein nicht näher gekennzeichneter Bereich auf dem bandförmigen Substrat 101, das von der Spenderrolle 102-1 abgewickelt wird. Eine nicht gezeigte Steuerungseinrichtung veranlasst eine nicht gezeigte Antriebseinrichtung zum Bewegen des bandförmigen Substrats 101, dass der Produktbereich auf dem bandförmigen Substrat 101 in eine erste Prozesszone 110 bewegt wird. Wenn sich der Produktbereich in der ersten Prozesszone 110 befindet, veranlasst die Steuerung die erste Antriebseinrichtung, das bandförmige Substrat anzuhalten. Im ersten Prozessbereich 110 wird dann beispielsweise der Produktbereich mit einer Lotpaste bedruckt, die beispielsweise Leiterbahnen repräsentieren. Nach dem Bedrucken des Substratmaterials in der ersten Prozesszone 110 wird das bandförmige Substrat durch die erste Antriebseinrichtung auf Anweisung der Steuerungseinrichtung in Bewegung versetzt, um den bedruckten Bereich des Bandes in die zweite Prozesszone 120 zu transportieren. Dort wird das Band wieder gestoppt und der bedruckte Teil des Substrats wird mit elektronischen Bauteilen bestückt.

Danach wird das bandförmige Substrat wieder in Bewegung gesetzt, so dass der Imagerohling I durch die Reflow-Lötanlage 130 transportiert wird. Das Image I bzw. der Imagerohling (d.h. das noch nicht fertig gestellte Produkt) passiert dabei die Punkte X1, X2, X3 und X4 eines bezüglich der Endlosfertigungsanlage ortsfesten Koordinatensystems. Bei einer kontinuierlichen Bewegung des bandförmigen Substrats 101 befindet sich beispielsweise ein Punkt P auf dem Image I zu einem Zeitpunkt t1 am Ort X1, zum Zeitpunkt t2 am Ort X2, zum Zeitpunkt t3 am Ort X3 und zum Zeitpunkt t4 am Ort X4. Der Imagerohling wird durch die Steuerungseinrichtung beispielsweise zum Punkt X3 bewegt. In dieser Zeit finden keine Bestückungs- oder Bedruckungsvorgänge im vorgelagerten Bandbereich statt. Der Imagerohling I wird beispielsweise zum Punkt X3 bewegt, während ein frisch bedruckter Bandabschnitt aus dem ersten Prozessbereich 110 in den zweiten Prozessbereich 120 gefördert wird.

Anzumerken ist, dass Fig. 1 nur eine schematische Darstellung der Anlage ist und keine maßstabgetreue Abbildung der Abstände zwischen den einzelnen Stationen und den Größen der Stationen selbst zeigt. Fig. 1 dient nur der Veranschaulichung der strukturellen Zusammensetzung der Anlage und veranschaulicht die Abläufe in der Anlage.

Am Punkt X3 wird der Imagerohling I angehalten, so dass in den Prozesszonen 110 und 120 der Bedruckungs- und Bestückungsvorgang auf dem bandförmigen Substrat begonnen werden kann. Zu diesem Zeitpunkt befindet sich die Wärmequelle W-1 und W2 beispielsweise am Punkt X4. Kurz nachdem das bandförmige Substrat angehalten wurde, veranlasst die Steuerungseinrichtung, dass sich die Wärmequelle W-1 in entgegengesetzter Richtung zur Bandtransportrichtung in Bewegung setzt und sich über den Imagerohling I bewegt. Durch Steuern der Geschwindigkeit der Wärmequelle W-1 und W-2 lässt sich die Temperatur und der Temperaturgradient, d.h. wie schnell sich die Temperatur an einem bestimmten Punkt auf dem Substrat ändert, einstellen, um ein kontrolliertes Aufschmelzen des Lots und Abkühlen des Lots zu erreichen, ohne die elektrischen Bauteile zu beschädigen.

Die Fig. 1 zeigt eine im Vergleich zum Image I relativ große Kammer 130, in der nur ein einzelnes Image I bearbeitet wird. Dies stellt jedoch nur eine vereinfachte schematische Darstellung der Anlage und des Vorgangs dar und soll auch die Flexibilität der Anlage veranschaulichen. Beispielsweise kann in der Kammer der Reflow-Lötprozessanordnung 130 ein sehr großes Image I bearbeitet werden oder mehrere kleine Images, so dass der gesamte Bewegungsbereich der Wärmequelle W-1 und W-2 vom Punkt X4 bis zum Punkt X2 genutzt werden kann.

Wenn alle Images in der Kammer der Reflow-Lötprozessanordnung 130 wärmebehandelt wurden, steht die Wärmequelle W-1 und W-2 am linken Ende der Kammer beispielsweise am Ort X2 und die Steuerungseinrichtung stoppt die Bewegung der Wärmequelle W-1 und W-2. Danach startet die Steuerungseinrichtung wieder die Bewegung des bandförmigen Substrats, so dass sich das Image I aus der Reflow-Lötprozessanordnung 130 herausbewegt und sich zur Aufnahmerolle 102-2 bewegt, wo die Produkte letztendlich aufgewickelt werden. Gleichzeitig mit dem Starten der Bewegung des bandförmigen Substrats 101 veranlasst die Steuerungseinrichtung, dass sich die Wärmequelle W-1 und W-2 mit dem Band 101 wieder zum anderen Ende der Kammer der Reflow-Lötprozessanordnung 130 bewegt. Während dieser Bewegung der Wärmequelle in der gleichen Richtung wie die Transportrichtung des Bandes schaltet die Steuerungseinrichtung die Wärmequelle W-1 und W-2 aus, so dass während dieser Zeit keine Wärmebehandlung stattfindet. Dies hat den Vorteil, dass die Images in der Kammer der Reflow-Lötprozessanordnung 130 kontrolliert abkühlen können und eine bessere thermische Trennung zu den nachfolgenden Images, die noch nicht wärmebehandelt sind, vorliegt. Beispielsweise können nachfolgende Images andere Produkte repräsentieren mit anderen elektrischen Bauteilen, die ein anderes Wärmeprofil benötigen. Durch das Zurückführen der Wärmequelle W-1 und W-2 auf die gegenüberliegende Seite der Kammer der Reflow-Lötprozessanordnung 130 im abgeschalteten Zustand wird der Einfluss des Wärmeprofils auf nachfolgende Images, die gegebenenfalls ein anderes Wärmeprofil benötigen, verringert. Weiterhin können während der Bewegung der Wärmequelle im abgeschalteten Zustand definierte Bereiche des bandförmigen Substrats gezielt abgekühlt werden, ohne benachbarte Bereiche zu beeinflussen, so dass reproduzierbarere Lötergebnisse erreicht werden.

Bei gleichbleibenden Produkten ist es jedoch auch möglich, die Wärmequelle W-1 und W-2 beim Zurückfahren eingeschaltet zu lassen. In diesem Fall ist die Bewegungsgeschwindigkeit der Wärmequelle W-1 und W-2 geringer als die Transportgeschwindigkeit des bandförmigen Substrats. Die Geschwindigkeitsdifferenz wird dabei so gewählt, dass ein kontinuierlicher Temperierungsprozess in der Reflow-Lötprozessanordnung 130 stattfindet mit einem konstanten Temperaturprofil, so dass eine kontinuierliche Relativbewegung zwischen der Wärmequelle und dem bandförmigen Substrat 101 mit konstanter Geschwindigkeit herrscht, obwohl die Bandbewegung getaktet ist und sich die Wärmequelle in der Kammer der Reflow-Lötprozessanordnung 130 ständig hin- und herbewegt.

In Fig. 1 ist die Wärmequelle der Einfachheit halber als punktförmige Wärmequelle oder linienförmige Wärmequelle über die gesamte Substratbreite dargestellt. Dies lässt sich beispielsweise über einen Heizdraht, der quer zur Laufrichtung über das Band führt oder einer Infrarotlaserdiode mit einer Optik, die die emittierte Infrarotstrahlung linienförmig quer über das Band auf die Oberfläche des Bands fokussiert, erreichen.

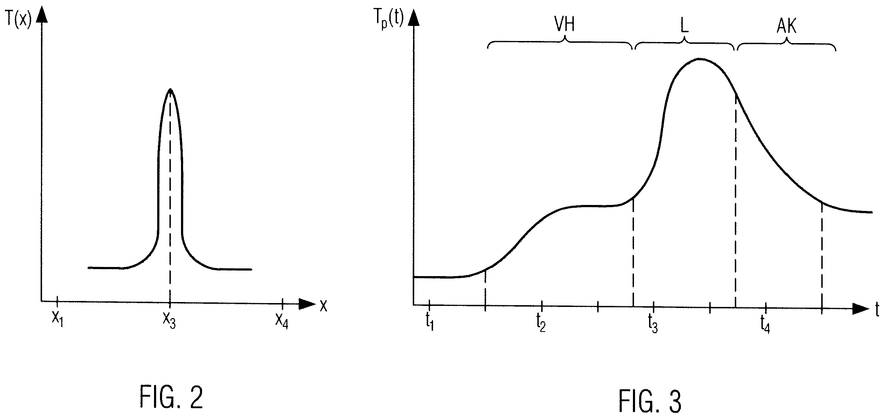

Fig. 2 zeigt ein Wärmefeld, das mit einer solchen punktförmigen Wärmequelle erreicht werden kann. Insbesondere zeigt Fig. 2 eine Temperaturverteilung für ein Wärmefeld einer punktförmigen Wärmequelle, die beispielsweise auf den Punkt P auf dem Image I in Fig. 1 fokussiert ist. Durch die fokussierte Wärmeenergie entsteht ein schmaler Temperaturpeak, der über das Image geführt wird. Abhängig von der Geschwindigkeit, mit der die Wärmequelle über das Image geführt wird, heizt sich die Oberfläche des Images mehr oder weniger auf. Beispielsweise wird die Geschwindigkeit so gewählt, dass die Temperatur am aufzuschmelzenden Lot ca. 230 °C beträgt. Abhängig von der Wärmekapazität und Wärmeleitfähigkeit des Substrats, des Lots und der elektronischen Bauteile kann die Geschwindigkeit variieren, mit der die Wärmequelle über das Image geführt werden muss, um diese Temperatur zum Aufschmelzen des Lots zu erreichen.

Im Falle einer nicht fokussierten Infrarotstrahlung wäre der in Fig. 2 dargestellte Peak breiter. Mit einem breiteren Peak lassen sich beispielsweise nur geringere Temperaturerhöhungsraten auf einen bestimmten Punkt in einem Image erzielen als bei einem fokussierten Infrarotstrahl. Der fokussierte Infrarotstrahl erlaubt eine präzisere Steuerung des Temperaturprofils, birgt aber das Risiko, dass die Temperatur auf dem Image an einem bestimmten Punkt zu schnell steigt, so dass das Image aufgrund von mechanischen Spannungen zwischen den sich unterschiedlich schnell ausdehnenden Materialien das Produkt beschädigt.

Fig. 3 zeigt ein typisches Temperaturprofil, wie es bei einem Reflow-Lötprozess benötigt wird. Das Lötprofil zeigt eine Veränderung der Temperatur mit der Zeit an einem bestimmten Punkt auf einem Image. Im Gegensatz dazu zeigt die Temperaturverteilung in der Fig. 2 eine räumliche Temperaturverteilung auf dem Image, d.h. unabhängig von der Zeit.

In Fig. 3 ist die Temperatur am Punkt P auf dem Image I aus der Fig. 1 dargestellt. Der Punkt P läuft bei Betrieb der Anlage vom Punkt X1 über Punkte X2 und X3 zum Punkt X4. Zum Zeitpunkt t1 befindet sich der Punkt P am Punkt X1 der Fertigungsanlage. Die dort herrschende Temperatur entspricht der Umgebungstemperatur außerhalb der Reflow-Lötprozessanordnung 130. Auf dem Weg vom Punkt X1 zum Punkt X2 läuft der Punkt P auf dem Image I durch einen Vorheizbereich 140-1 (siehe Fig. 1), wo das Substrat auf ca. 100°C aufgeheizt wird. Dies entspricht dem Bereich VH (Vorheizen) in Fig. 3. Zum Zeitpunkt t3 befindet sich der Punkt P etwa am Punkt X3 innerhalb der Reflow-Lötprozessanordnung 130 und das Band 101 steht. Gleichzeitig hat sich die Wärmequelle W-1 und W-2 über den Punkt P hinwegbewegt, so dass ein relativ steiler Anstieg der Temperatur am Punkt P zu verzeichnen ist. In diesem Bereich erhöhter Temperaturen findet der Lötprozess statt, indem das Lot aufgeschmolzen wird und sich mit dem Substrat und den Anschlüssen der Bauelemente verbindet. Dieser Lötbereich wird in der Fig. 3 mit L (Löten) gekennzeichnet. Wenn die Wärmequelle den Punkt P passiert hat, fängt der Punkt P an sich abzukühlen, je weiter sich die Wärmequelle von dem Punkt P entfernt, bis zum Abschalten der Wärmequelle. Danach wird die Bandbewegung wieder eingeschaltet und der Punkt P bewegt sich in Richtung Punkt X4, den er zum Zeitpunkt t4 erreicht. Die nachgelagerte Wärmequelle 140-2 am Ausgang der Reflow-Lötprozessanordnung 130 sorgt dafür, dass keine unkontrollierten Wärmeverluste durch Wärmeleitung über das Band 101 erfolgt, so dass die Temperatur am Punkt X4, d.h. ca. zum Zeitpunkt t4 beispielsweise ca. 100 °C beträgt.

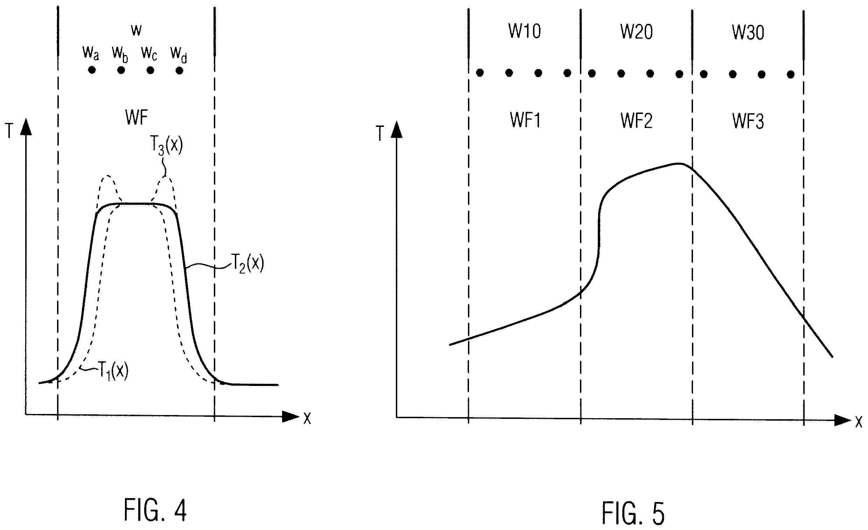

Wie oben bereits erwähnt und gemäß der Erfindung, hängt ein erforderliches Temperaturprofil T(t) von der Struktur des Produkts und deren Parameter wie beispielsweise Wärmekapazität und Wärmeleitfähigkeit des Substrats, des Lots und der Bauteile ab, so dass gegebenenfalls das erforderliche Temperaturprofil mit einer punktförmigen Wärmequelle schwer zu erreichen ist. In diesem Fall und gemäß der Erfindung ist die Wärmequelle in Form einer gerasterten Wärmematrix bestehend aus einem oder mehreren individuell Steuer- bzw.regelbaren Feldern ausgebildet. Fig. 4 zeigt eine Wärmequelle W mit vier Segmenten Wa, Wb, Wc und Wd, mit denen ein komplexeres Wärmefeld WF realisiert werden kann. Fig. 5 zeigt ein Array aus drei nebeneinanderliegenden gerasterten Wärmequellen W10, W20 und W30, die drei verschiedene räumliche getrennte Wärmefelder WF1, WF2 und WF3 erzeugen können.

Fig. 4 zeigt drei verschiedene Wärmefelder WF, die mit der gerasterten Wärmequelle W beispielhaft realisiert werden können, wenn die einzelnen Segmente Wa, Wb, Wc und Wd individuell eingestellt werden können. Die Temperaturverteilung T₁(X) zeigt einen Fall, wo die Intensität der äußeren Wärmequellen Wa und Wd kleiner eingestellt ist als die Intensität der mittleren Segmente Wb und Wc. T₂(X) zeigt ein Wärmefeld WF, bei dem alle Segmente die gleiche Intensität beisteuern. Die Temperaturverteilung T₃(X) des Wärmefelds WF zeigt einen Fall, wo die äußeren Segmente Wa und Wd eine höhere Intensität im Wärmefeld aufweisen als die mittleren Segmente Wb und Wc. Die Temperaturverteilung T₁(X) führt zu flacheren Temperaturprofilen, während das andere extrem, die Temperaturverteilung T₃(X) für Temperaturprofile verwendet werden kann, die ein schnelleres lokales Aufheizen erfordern.

Fig. 5 zeigt eine Wärmequelle, in der der Vorheizbereich und der Abkühlbereich in der Wärmequelle bereits integriert sind und zusammen mit dem Lötbereich über das Image bewegt werden. Das Wärmefeld WF1 dient beispielsweise dem Vorheizen, das Wärmefeld WF2 dient dem Löten und das Wärmefeld WF3 dient der Abkühlung.

Solch komplexe Wärmefelder müssen nicht notwendigerweise mit Wärmequellen nach demselben Bauprinzip realisiert werden, sondern können auch unterschiedliche Techniken integrieren. Beispielsweise kann das Wärmefeld WF1 mit einem Infrarotstrahler realisiert werden, das Wärmefeld WF2 mit einer Konvektionswärmequelle und das Wärmefeld WF3 mit einer Kühlplatte. Es lassen sich beliebige Techniken kombinieren wie beispielsweise Infrarotstrahler, fokussierte Infrarotstrahler, beheizte Wärmeleiter wie z.B. Wärmeplatten oder Kühlplatten, eine Konvektionswärmequelle, eine Kondensationswärmequelle, eine Wärmequelle auf der Basis von Infrarotlaser, Infrarothalbleiterlaser, VCSEL-Geräte (vertical-cavity surfaceemitting laser) oder Infrarotleuchtdioden.

Um die Reproduzierbarkeit des Lötvorgangs zu erhöhen, können verschiedene Regelvorgänge verwendet werden, um die Temperaturprofile reproduzierbarer und genauer einzustellen. Beispielsweise können mit Temperatursensoren in der Reflow-Lötanlage ein Temperaturprofil bzw. eine Temperaturverteilung in der Anlage gemessen werden und auf der Basis dieser Werte können Verfahrensparameter so eingestellt werden, dass das für den Lötprozess erforderliche Temperaturprofil möglichst genau und reproduzierbar eingestellt wird. Beispielsweise lässt sich das Temperaturprofil durch Ändern der Transportgeschwindigkeit des bandförmigen Substrats, der Bewegungsgeschwindigkeit der Wärmequelle und durch individuelles Einstellen einzelner Segmente der segmentierten Wärmequelle bzw. durch Einstellen der Wärmefelder in einem Wärmefeldarray (siehe Fig. 5) das Temperaturprofil modifizieren. Zur Messung der Temperatur können Pyrometer, Thermofühler, Thermoelemente, Thermokamera oder Kombinationen daraus verwendet werden. Es können eine Vielzahl von Temperaturmesseinrichtungen verwendet werden, die in der Reflow-Lötprozessanordnung verteilt sind, oder es kann ein einzelner Sensor verwendet werden, der relativ zu einem bestimmten Punkt P auf einem Image I mitgeführt wird.

## Patentansprüche

1. Endlosfertigungsanlage (100) zum Verarbeiten eines bandförmigen Substrats (101), die Folgendes umfasst:
eine erste Antriebseinrichtung zum Bewegen des bandförmigen Substrats (101) in einer Transportrichtung (X); und
mindestens zwei Prozesszonen (110, 120, 130), durch die das bandförmige Substrat (101) läuft, so dass unterschiedliche Bereiche des bandförmigen Substrats gleichzeitig bearbeitet werden können,
wobei die mindestens zwei Prozesszonen (110, 120, 130) Folgendes umfassen:
eine erste Prozesszone (110, 120), und
eine zweite Prozesszone mit einer Reflow-Lötprozessanordnung (130), wobei die Reflow-Lötprozessanordnung (130) mindestens eine Wärmequelle (W) umfasst; und
eine zweite Antriebseinrichtung zum Bewegen der Wärmequelle (W) relativ zu der ersten Prozesszone (110, 120) entlang des bandförmigen Substrats (101), die dafür ausgelegt ist, die Wärmequelle (W) relativ zu der ersten Prozesszone (110,120) entlang des bandförmigen Substrats (101) entgegen der Transportrichtung (X) des bandförmigen Substrats (101) zu bewegen, selbst wenn die erste Antriebseinrichtung stillsteht
**gekennzeichnet durch** :
eine Steuerungseinrichtung, die ausgelegt ist, die zweite Antriebseinrichtung so zu steuern, dass die Wärmequelle (W) so bewegt wird, dass ein für den Lötprozess erforderliches vorbestimmtes Temperaturprofil T(t) über einem vorbestimmten Bereich (P) des bandförmigen Substrats (101) erreicht wird,
wobei das vorbestimmte Temperaturprofil T(t) über dem vorbestimmten Bereich (P) des bandförmigen Substrats (101) einen Bereich zum Vorheizen (VH), einen Lötbereich (L) und einen Abkühlbereich (AK) umfasst, die von der Struktur des Produkts, der Wärmekapazität und Wärmeleitfähigkeit des Substrats, des Lots und der Bauteile abhängen, und
wobei die Steuerungseinrichtung ausgelegt ist, die Intensität der mindestens einen Wärmequelle abhängig von dem vorbestimmten Temperaturprofil so zu steuern, dass ein Wärmefeld mit einer vorgegebenen Temperaturverteilung entsteht, wobei die Wärmequelle (W) in Form einer gerasterten Wärmematrix bestehend aus mehreren individuell Steuer- bzw.regelbaren Feldern (Wₐ, W_{b},W_{c}, W_{d}) ausgebildet ist.

2. Endlosfertigungsanlage (100) nach Anspruch 1, wobei die Steuerungseinrichtung ausgelegt ist, die Transportgeschwindigkeit des bandförmigen Substrats abhängig von der Produktlänge und/oder dem vorbestimmten Temperaturprofil zu steuern.

3. Endlosfertigungsanlage (100) nach Anspruch 1, oder 2, wobei die mindestens eine Wärmequelle segmentiert ist, so dass sie ein Wärmefeld (WF) oder mehrere räumlich getrennte Wärmefelder (WF1, WF2, WF3) mit einer vorgegebenen Temperaturverteilung T(x) erzeugen kann.

4. Endlosfertigungsanlage (100) nach einem der Ansprüche 1 - 3, wobei am Einlauf und/oder Auslauf der zweiten Prozesszone zusätzliche Wärmequellen stationär oder mit dem bandförmigen Substrat bewegbar angeordnet sind.

5. Endlosfertigungsanlage (100) nach einem der Ansprüche 2 - 4, das weiterhin mindestens eine Temperaturmesseinrichtung umfasst, über die die Steuerungseinrichtung die Bewegung des bandförmigen Substrats und/oder die Bewegung der mindestens einen Wärmequelle und/oder die die Form des Wärmefeldes der Wärmequelle steuern kann, um ein gewünschtes Wärmeprofil zu erreichen.

6. Endlosfertigungsanlage (100) nach Anspruch 5, wobei die Temperaturmesseinrichtung ein Pyrometer, einen Thermofühler, ein Thermoelement, eine Thermokamera oder Kombinationen daraus umfasst.

7. Endlosfertigungsanlage (100) nach einem der Ansprüche 1 - 6, wobei die Wärmequelle einen Infrarot-Strahler, einen beheizten Wärmeleiter, eine Konvektionswärmequelle, eine Kondensationswärmequelle, eine Laser-Wärmequelle oder eine Kombination daraus umfasst.

8. Verfahren zur Endlosfertigung eines Produkts auf einem bandförmigen Substrat, das sich in einer Transportrichtung durch mehrere Prozesszonen bewegt, wobei unterschiedliche Bereiche des bandförmigen Substrats in unterschiedlichen Prozesszonen gleichzeitig bearbeitet werden, und
**dadurch gekennzeichnet dass**,
in einer zweiten Prozesszone ein kontinuierlicher Wärmebehandlungsprozess abläuft, bei der sich eine Wärmequelle in Form einer gerasterten Wärmematrix bestehend aus mehreren individuell steuer- bzw. regelbaren Feldern relativ zum bandförmigen Substrat bewegt, und in einer ersten Prozesszone ein diskontinuierlicher Prozess abläuft, bei der ein Prozesswerkzeug relativ zum bandförmigen Substrat stillsteht,
und weiter **gekennzeichnet durch** folgende Schritte :
einem ersten Verfahrensschritt des Anhaltens des bandförmigen Substrats; und
einem zweiten Verfahrensschritt des Bewegens der Wärmequelle in der zweiten Prozesszone in entgegengesetzter Richtung zur Transportrichtung des bandförmigen Substrats und gleichzeitiges Bearbeiten des Substrats in der ersten Prozesszone, der zweite Verfahrensschritt umfasst: Steuern der zweiten Antriebseinrichtung mit einer Steuerungseinrichtung, so dass die Wärmequelle (W) so bewegt wird, dass ein vorbestimmtes Temperaturprofil T(t) über einem vorbestimmten Bereich (P) des bandförmigen Substrats (101) erreicht wird,
wobei das vorbestimmte Temperaturprofil T(t) über dem vorbestimmten Bereich (P) des bandförmigen Substrats (101) einen Bereich zum Vorheizen (VH), einen Bereich erhöhter Temperatur (L) und einen Abkühlbereich (AK) umfasst, die von der Struktur des Produkts, der Wärmekapazität und Wärmeleitfähigkeit des Substrats, des Lots und der Bauteile abhängen, wobei der zweite Verfahrensschritt weiterhin umfasst:
Einschalten und Steuern der Wärmequelle, um ein vorgegebenes Temperaturprofil zu erzeugen,

9. Verfahren nach Anspruch 8, wobei das Steuern der Wärmequelle mindestens eins des Folgenden umfasst:
Steuern der Intensität der Wärmequelle oder von Segmenten einer Segmentierten Wärmequelle, um ein Wärmefeld mit vorgegebener Temperaturverteilung zu erzeugen; und
Steuern der Bewegung der Wärmequelle.

10. Verfahren nach einem der Ansprüche 8 - 9, wobei der zweite Verfahrensschritt weiterhin umfasst:
Erfassen der Temperatur an mindestens einer Stelle des bandförmigen Substrats in der zweiten Prozesszone;
Messen eines Temperaturprofils des bandförmigen Substrats in der zweiten Prozesszone;
Vergleichen des gemessenen Temperaturprofils mit dem vorgegebenen Temperaturprofil; und
Steuern der Wärmequelle, um eine Differenz dem vorgegebenen und dem gemessenen Temperaturprofil zu minimieren.

11. Verfahren nach einem der Ansprüche 8 - 10, das weiterhin folgende Verfahrensschritte umfasst:
einen dritten Verfahrensschritt des Startens der Transportbewegung des bandförmigen Substrats; und
einen vierten Verfahrensschritt des Umkehrens der Bewegungsrichtung der Wärmequelle.

12. Verfahren nach Anspruch 11, wobei der vierte Verfahrensschritt weiterhin das Ausschalten der Wärmequelle umfasst.

13. Verfahren nach einem der Ansprüche 8 - 12, das weiterhin folgende Verfahrensschritte umfasst:
einen dritten Verfahrensschritt des Startens der Transportbewegung des bandförmigen Substrats;
einen vierten Verfahrensschritt des Umkehrens der Bewegungsrichtung der Wärmequelle, wobei die Bewegung der Wärmequelle so gesteuert wird, dass immer eine Relativbewegung mit konstanter Geschwindigkeit zwischen Heizquellen und Substrat vorliegt, selbst wenn das bandförmige Substrat relativ zu der zweiten Prozesszone ruht.

## Claims

1. Continuous manufacturing plant (100) for processing a strip-like substrate (101), comprising:
a first drive apparatus for moving the strip-like substrate (101) in a direction of transport (X); and
at least two process zones (110, 120, 130) which the strip-like substrate (101) passes through, so that different regions of the strip-like substrate may be processed simultaneously,
wherein the at least two process zones (110, 120, 130) comprise:
a first process zone (110, 120), and
a second process zone with a reflow soldering process arrangement (130), wherein the reflow soldering process arrangement (130) comprises at least one source of heat (W); and
a second drive apparatus for moving the source of heat (W) relative to the first process zone (110, 120) along the strip-like substrate (101) which is configured to move the source of heat (W) relative to the first process zone (110, 120) along the strip-like substrate (101) opposed to the direction of transport (X) of the strip-like substrate (101) even if the first drive apparatus is standing still.
**characterized by:**
a control device which is configured to control the second drive apparatus such that the source of heat (W) is moved such that a predetermined temperature profile T(t) required for the soldering process is reached over a predetermined region (P) of the strip-like substrate (101),
wherein the predetermined temperature profile T(t) over the predetermined region (P) of the strip-like substrate (101) comprises a region for preheating (VH), a solder region (L) and a cool down region (AK), which depend on a structure of the product, the heat capacity and heat conductivity of the substrate, the solder paste and the components, and
wherein the control device is configured to control the intensity of the at least one source of heat depending on the predetermined temperature profile such that a heat field with a predetermined temperature distribution is formed,
wherein the source of heat (W) is formed as a screened heat matrix consisting of several individually controllable fields (Wₐ, W_{b}, W_{c}, W_{d}).

2. Continuous manufacturing plant (100) according to claim 1, wherein the control device is configured to control the transport speed of the strip-like substrate depending on the product length and/or the predetermined temperature profile.

3. Continuous manufacturing plant (100) according to claim 1 or 2, wherein the at least one source of heat is segmented, so that it may generate a heat field (WF) or a plurality of spatially separated heat fields (WF1, WF2, WF3) with a predetermined temperature distribution T(x).

4. Continuous manufacturing plant (100) according to one of claims 1 - 3, wherein at the inlet and/or outlet of the second process zone, additional sources of heat are arranged stationarily or movably together with the strip-like substrate.

5. Continuous manufacturing plant (100) according to one of claims 2 - 4, furthermore comprising at least one temperature measurement device by which the control device may control the movement of the strip-like substrate and/or the movement of the at least one source of heat and/or the shape of the heat field of the source of heat to obtain a desired heat profile.

6. Continuous manufacturing plant (100) according to claim 5, wherein the temperature measurement device comprises a pyrometer, a thermo sensor, a thermoelement, a thermal imaging camera or combinations thereof.

7. Continuous manufacturing plant (100) according to one of claims 1 - 6, wherein the source of heat is an infrared radiator, a heated heat conductor, a convective source of heat, a condensation source of heat, a laser source of heat or a combination thereof.

8. Method for the continuous manufacture of a product on a strip-like substrate that moves through a plurality of process zones in a direction of transport, wherein different regions of the strip-like substrate are simultaneously processed in different process zones and
**characterized in that**
in a second process zone, a continuous heat treatment process is performed, wherein a source of heat in form of a screened heat matrix consisting of several individually controllable fields is moving relative to the strip-like substrate, and in a first process zone, a discontinuous process is performed wherein a process tool is standing still relative to the strip-like substrate,
and further **characterized by** the following steps:
a first process step of stopping the strip-like substrate; and
a second process step of moving the source of heat in the second process zone in a direction opposed to the direction of transport of the strip-like substrate and simultaneously processing said substrate in the first process zone,
wherein the second process step comprises: controlling the second drive apparatus with a control device such that the source of heat (W) is moved such that a predetermined temperature profile T(t) is reached over a predetermined region (P) of the strip-like substrate (101),
wherein the predetermined temperature profile T(t) over the predetermined region (P) of the strip-like substrate (101) comprises a region for preheating (VH), a solder region (L) and a cool down region (AK), which depend on a structure of the product, the heat capacity and heat conductivity of the substrate, the solder paste and the components, and
wherein the second process step further comprises:
switching on and controlling the source of heat to generate a predetermined temperature profile.

9. Method according to claim 8, wherein controlling the source of heat comprises at least one of:
controlling the intensity of the source of heat or of segments of a segmented source of heat to generate a heat field with a predetermined temperature distribution; and
controlling the movement of the source of heat.

10. Method according to one of claims 8 -9, wherein the second process step furthermore comprises:
detecting the temperature at least at one point of the strip-like substrate in the second process zone;
measuring a temperature profile of the strip-like substrate in the second process zone;
comparing the measured temperature profile with the predetermined temperature profile; and
controlling the source of heat to minimize a difference the predetermined and the measured temperature profile.

11. Method according to one of claims 8 -10, furthermore comprising the following process steps:
a third process step of starting the transport motion of the strip-like substrate; and
a fourth process step of reversing the moving direction of the source of heat.

12. Method according to claim 11, wherein the fourth procedure step furthermore comprises switching off the source of heat.

13. Method according to one of claims 8 -12, furthermore comprising the following procedure steps:
a third procedure step of starting the transport motion of the strip-like substrate;
a fourth procedure step of reversing the moving direction of the source of heat, wherein the movement of the source of heat is controlled in such a way that there always is a relative motion at a constant speed between the sources of heat and the substrate, even if the strip-like substrate is at rest relative to the second process zone.

## Revendications

1. Installation de fabrication sans fin (100) pour assurer le traitement d'un substrat (101) sous forme de bande, qui comprend :
un premier dispositif d'entraînement pour déplacer le substrat (101) sous forme de bande dans une direction de transport (X) ; et
au moins deux zones de processus (110, 120, 130) à travers lesquelles circule le substrat (101) sous forme de bande, de sorte que des zones différentes du substrat sous forme de bande peuvent être traitées simultanément, lesdites au moins deux zones de processus (110, 120, 130) comprenant :
une première zone de processus (110, 120), et
une deuxième zone de processus avec un agencement de processus de brasage par refusion (130), l'agencement de processus brasage par refusion (130) comportant au moins une source de chaleur (W) ; et
un deuxième dispositif d'entraînement pour déplacer la source de chaleur (W) par rapport à la première zone de processus (110, 120) le long du substrat (101) sous forme de bande, et qui est conçu pour déplacer la source de chaleur (W) par rapport à la première zone de processus (110, 120) le long du substrat (101) sous forme de bande, à l'encontre de la direction de transport (X) du substrat (101) sous forme de bande, même lorsque le premier dispositif d'entraînement est à l'arrêt,
**caractérisée par**
un dispositif de commande qui est conçu pour commander le deuxième dispositif d'entraînement de manière telle, que la source de chaleur (W) soit déplacée de façon à obtenir un profil de température T(t) prédéterminé nécessaire au processus de brasage, le long d'une zone prédéterminée (P) du substrat (101) sous forme de bande, le profil de température T(t) prédéterminé le long de la zone prédéterminée (P) du substrat (101) sous forme de bande comprenant une zone de préchauffage (VH), une zone de brasage (L) et une zone de refroidissement (AK), qui dépendent de la structure du produit, de la capacité calorifique et de la conduction thermique du substrat, de la brasure et des composants, et
le dispositif de commande étant conçu pour commander l'intensité de ladite au moins une source de chaleur en fonction du profil de température prédéterminé, de manière que s'établisse un champ thermique avec une répartition de température prescrite,
et la source de chaleur (W) étant réalisée sous la forme d'une matrice de chauffage tramée, constituée de plusieurs champs (Wₐ, W_{b}, W_{c}, W_{d}) pouvant être commandés et régulés individuellement.

2. Installation de fabrication sans fin (100) selon la revendication 1, dans laquelle le dispositif de commande est conçu pour commander la vitesse de transport du substrat sous forme de bande, en fonction de la longueur de produit et/ou du profil de température prédéterminé.

3. Installation de fabrication sans fin (100) selon la revendication 1 ou la revendication 2, dans laquelle ladite au moins une source de chaleur est segmentée, de manière à pouvoir produire un champ thermique (WF) ou plusieurs champs thermiques (WF1, WF2, WF3) séparés spatialement, avec une répartition de température (Tx) prescrite.

4. Installation de fabrication sans fin (100) selon l'une des revendications 1 - 3, dans laquelle à l'entrée et/ou à la sortie de la deuxième zone de processus, sont agencées des sources de chaleur supplémentaires, stationnaires ou mobiles avec le substrat sous forme de bande.

5. Installation de fabrication sans fin (100) selon l'une des revendications 2 - 4, qui comprend, en outre, au moins un dispositif de mesure de température, par l'intermédiaire duquel le dispositif de commande peut commander le mouvement du substrat sous forme de bande, et/ou le mouvement de ladite au moins une source de chaleur, et/ou la forme du champ thermique de la source de chaleur, en vue d'obtenir un profil thermique souhaité.

6. Installation de fabrication sans fin (100) selon la revendication 5, dans laquelle le dispositif de mesure de température comprend un pyromètre, une sonde thermique, un thermo-élément, une caméra thermique ou une combinaison de ceux-ci.

7. Installation de fabrication sans fin (100) selon l'une des revendications 1 - 6, dans laquelle la source de chaleur comprend un radiateur à infrarouge, un conducteur thermique chauffant, une source de chaleur de convection, une source de chaleur de condensation, une source de chaleur laser ou une combinaison de ceux-ci.

8. Procédé pour la fabrication sans fin d'un produit sur un substrat sous forme de bande, qui se déplace dans une direction de transport à travers plusieurs zones de processus, différentes zones du substrat sous forme de bande étant traitées simultanément dans des zones de processus différentes, et
**caractérisé en ce que** dans une deuxième zone de processus se déroule un processus de traitement thermique continu lors duquel une source de chaleur, sous la forme d'une matrice de chauffage tramée constituée de plusieurs champs pouvant être commandés et régulés individuellement, est déplacée par rapport au substrat sous forme de bande, et dans une première zone de processus se déroule un processus discontinu lors duquel un outillage de processus est immobile par rapport au substrat sous forme de bande,
et par ailleurs **caractérisé par** les étapes suivantes :
une première étape de procédé consistant à arrêter le substrat sous forme de bande ; et
une deuxième étape de procédé consistant à déplacer la source de chaleur dans la deuxième zone de processus dans une direction opposée à la direction de transport du substrat sous forme de bande, et à traiter simultanément le substrat dans la première zone de processus, la deuxième étape de procédé comprenant : la commande du deuxième dispositif d'entraînement à l'aide d'un dispositif de commande, de manière telle que la source de chaleur (W) soit déplacée de façon à obtenir un profil de température T(t) prédéterminé le long d'une zone prédéterminée (P) du substrat (101) sous forme de bande,
le profil de température T(t) prédéterminé le long de la zone prédéterminée (P) du substrat (101) sous forme de bande comprenant une zone pour le préchauffage (VH), une zone de température plus élevée (L) et une zone de refroidissement (AK), qui dépendent de la structure du produit, de la capacité calorifique et de la conduction thermique du substrat, de la brasure et des composants, la deuxième étape de procédé comprenant par ailleurs :
la mise en marche et la commande de la source de chaleur en vue de produire un profil de température prescrit.

9. Procédé selon la revendication 8, d'après lequel la commande de la source de chaleur comprend au moins l'une des procédures suivantes :
la commande de l'intensité de la source de chaleur ou de segments d'une source de chaleur segmentée, en vue de produire un champ thermique avec une répartition de température prescrite ; et
la commande du mouvement de déplacement de la source de chaleur.

10. Procédé selon l'une des revendications 8 - 9, d'après lequel la deuxième étape de procédé comprend en outre :
le relevé de la température en au moins un endroit du substrat sous forme de bande, dans la deuxième zone de processus ;
la mesure d'un profil de température du substrat sous forme de bande dans la deuxième zone de processus ;
la comparaison du profil de température mesuré au profil de température prescrit ; et
la commande de la source de chaleur en vue de minimiser une différence entre le profil de température prescrit et celui mesuré.

11. Procédé selon l'une des revendications 8 - 10, qui comprend en outre les étapes de procédé suivantes :
une troisième étape de procédé consistant au démarrage du mouvement de transport du substrat sous forme de bande ; et
une quatrième étape de procédé consistant à inverser la direction de déplacement de la source de chaleur.

12. Procédé selon la revendication 11, d'après lequel la quatrième étape de procédé comprend par ailleurs la mise à l'arrêt de la source de chaleur.

13. Procédé selon l'une des revendications 8 - 12, qui comprend en outre les étapes de procédé suivantes :
une troisième étape de procédé consistant au démarrage du mouvement de transport du substrat sous forme de bande ;
une quatrième étape de procédé consistant à inverser la direction de déplacement de la source de chaleur, le mouvement de déplacement de la source de chaleur étant commandé de manière telle, qu'il existe toujours un mouvement relatif à vitesse constante entre les sources de chaleur et le substrat, même lorsque le substrat sous forme de bande est au repos par rapport à la deuxième zone de processus.
